Europäisches Patentamt

European Patent Office

Office européen des brevets

(11) Publication number: **0 604 686 A1**

# EUROPEAN PATENT APPLICATION

(21) Application number: **92204089.4**

(22) Date of filing: **28.12.92**

(51) Int. Cl.5: **H03F 3/393**, H03H 19/00

(43) Date of publication of application:
**06.07.94 Bulletin 94/27**

(84) Designated Contracting States:
**DE FR GB IT**

(71) Applicant: **PHILIPS ELECTRONICS N.V.**
**Groenewoudseweg 1**
**NL-5621 BA Eindhoven(NL)**

(72) Inventor: **Seevinck, Evert, Int.Octrooibureau**
**B.V.**
**Prof. Holstlaan 6**
**NL-5656 AA Eindhoven(NL)**
Inventor: **Bolt, Jacob Hendrik, c/o Int.**
**Octrooibureau B.V.**
**Prof. Holstlaan 6**
**NL-5656 AA Eindhoven(NL)**

(74) Representative: **Schoonheijm, Harry Barend et**
**al**
**INTERNATIONAAL OCTROOIBUREAU B.V.,**
**Prof.Holstlaan 6**
**NL-5656 AA Eindhoven (NL)**

(54) Switched coupling network for a.c. signals in (BI)MOS.

(57) To convert a (low-frequency) output signal of a first stage (10) into a (low-frequency) input signal for a second stage (20) an integrated coupling network comprising a capacitance (35, 36) is provided with an output transistor (37, 38) having a control electrode coupled to an input terminal (31, 32) *via* the capacitance (35, 36) and having a main current path coupled between a first reference terminal (41) and an output terminal (33, 34), and with a MOS transistor (39, 40) having a control electrode coupled to a terminal (30) for receiving a pulse signal and having a main current path coupled between a second reference terminal (42) and the control electrode of the output transistor (37, 38). Since the pulse signal is applied to the terminal (30) the integrated coupling network is suitable for the low-frequency input signal.

EP 0 604 686 A1

The invention relates to an integrated coupling network for converting an output signal of a first stage into an input signal for a second stage, which coupling network comprises a first input terminal for receiving the output signal, a first output terminal for supplying the input signal, and a first capacitance arranged between the first input terminal and the first output terminal.

Such a coupling network can be used in an integrated semiconductor circuit to couple a first stage, for example a preamplifier stage, and a second stage, for example an output amplifier stage.

Such a coupling network is generally known. An amplifier arrangement usually employs a plurality of amplifier stages in order to control and amplify a signal. Since the individual amplifier stages generally have a separate d.c. bias a coupling network is arranged between the relevant amplifier stages, which coupling network ensures an independent setting of the d.c. levels.

In a simple form such a coupling network comprises a capacitance and a resistance, the capacitance being arranged as described above and the resistance being arranged between a voltage terminal and the output terminal. The resulting coupling network has a high-pass characteristic, the characteristic being determined by the capacitance and the resistance and a capacitance of five picofarads being a high capacitance value (in a (BI)MOS process). A major drawback of such a coupling network is the aforementioned characteristic. When a characteristic having a cut-off frequency of (for example) one Hertz is required the capacitance value makes it necessary to have a resistance value of thirty gigohms. Such a resistance value is undesirable because the relevant value requires a large chip area.

An additional drawback of such a coupling network is that the resistance may affect the d.c. setting of the second stage.

It is an object of the invention to provide an integrated coupling network fabricated in a (BI)MOS process, which coupling network can be realized in a simple manner and combines a small chip area with a low cut-off frequency.

A first embodiment of an integrated coupling network in accordance with the invention is characterized in that the coupling network further comprises a first output transistor having a control electrode coupled to the first input terminal *via* the first capacitance and having a main curtent path coupled between a first reference terminal and the first output terminal, and a first MOS transistor having a control electrode coupled to a terminal for receiving a pulse signal and having a main current path coupled between a second reference terminal and the control electrode of the first output transistor.

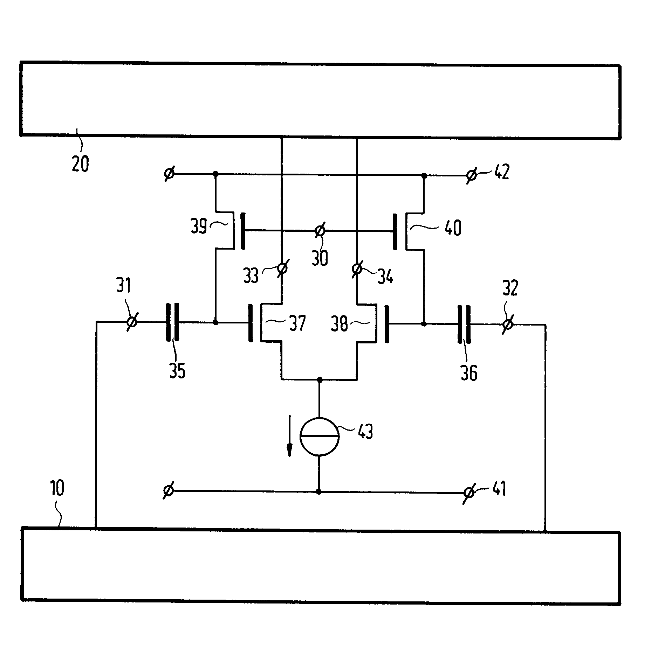

In the present embodiment the capacitance and the MOS transistor, which is switched by means of a pulse signal, provide a characteristic whose cut-off frequency is determined by the capacitance, the MOS transistor and the pulse signal. As a result of the pulse signal the MOS transistor can simply simulate a high resistance although the required chip area is low. This will be substantiated by means of an explanation given below with reference to the accompanying drawing.

An additional advantage of the present embodiment concerns the d.c. level at the output terminal of the coupling network in accordance with the invention. When the main current path of the output transistor is coupled to the output terminal by means of an electrode which is inverting relative to the control electrode the d.c. level will not be set to a specific value and the d.c. setting of the second stage will not be influenced.

A preferred embodiment of an integrated coupling network in accordance with the invention is characterized in that the coupling network further comprises a second input terminal for receiving the output signal, a second output terminal for supplying the input signal, a second capacitance, a second output transistor having a control electrode coupled to the second input terminal *via* the second capacitance and having a main current path coupled between the first reference terminal and the second output terminal, and a second MOS transistor having a control electrode coupled to the terminal for receiving the pulse signal and having a main current path coupled between the second reference terminal and the control electrode of the second output transistor. A further advantage provided by the preferred embodiment is that the coupling network converts a differential input signal into a differential output signal, the differential construction ensuring that the effect of a disturbance (caused by, for example, an undesired voltage ripple) is minimal. Generally, the first and the second output transistor will be arranged as a differential pair, their main current paths being coupled to the second reference terminal by means of a current source.

A further embodiment of an integrated coupling network in accordance with the invention is characterized in that the first reference terminal is connected to the second reference terminal.

When a reference voltage and the pulse signal are applied to the further embodiment this embodiment can be used in a simple manner.

The above and other (more detailed) aspects of the invention will be described more elaborately with reference to the accompanying Figure, which

Figure shows an embodiment of an integrated coupling network in accordance with the invention.

The accompanying Figure shows an embodiment of an integrated coupling network in accordance with the invention. This Figure shows a first stage 10 and a second stage 20, which stages are coupled by means of a coupling network in order to provide d.c. isolation. The coupling network shown in the Figure is adapted to convert a (differential) output signal of the stage 10 into a (differential) input signal for the stage 20. The coupling network comprises a first input terminal 31 and a second input terminal 32 for receiving the output signal of the stage 10 and the coupling network comprises a first output terminal 33 and a second output terminal 34 for supplying the input signal to the stage 20. The coupling network further comprises a first capacitance 35, a second capacitance 36, a first output transistor 37 having a control electrode coupled to the input terminal 31 *via* the capacitance 35 and having a main current path coupled between a first reference terminal 41 and the output terminal 33, a second output transistor 38 having a control electrode coupled to the input terminal 32 *via* the capacitance 36 and having a main current path coupled between the reference terminal 41 and the output terminal 34, a first MOS transistor 39 having a control electrode coupled to a terminal 30 for receiving a pulse signal and having a main current path coupled between a second reference terminal 42 and the control electrode of the output transistor 37, and a second MOS transistor 40 having a control electrode coupled to the terminal 30 for receiving the pulse signal and having a main current path coupled between the reference terminal 42 and the control electrode of the output transistor 38. When a reference voltage is applied to the reference terminals 41 and 42, for which reference voltage the reference terminal 41 is negative relative to the reference terminal 42, the MOS transistors 39 and 40 will generally be of a P-type and the output transistors 37 and 38 will generally be of an N-type, as a result of which N-type the output terminals 33 and 34 will be at an indeterminate d.c. level. When a reference voltage is applied to the reference terminals 41 and 42, for which reference voltage the reference terminal 41 is positive relative to the reference terminal 42, the MOS transistors 39 and 40 will generally be of an N-type and the output transistors 37 and 38 will generally be of a P-type, as a result of which N-type the output terminals 33 and 34 will be at an indeterminate d.c. level. While the MOS transistors 39 and 40 establish a d.c. level on the control electrodes of the output transistors 37 and 38 a current will flow in the output transistors 37 and 38, which current is determined by a current source 43. The output transistors 37 and 38 may be of a unipolar type or of a bipolar type, the unipolar type having the advantage that the respective control electrodes remain currentless. When the present coupling network is dimensioned symmetrically the coupling network will have a characteristic with a single cut-off frequency, which cut-off frequency is determined by the capacitance 35 (36), the MOS transistor 39 (40) and the pulse signal. Since the MOS transistor 35 (36) is switched by means of the pulse signal the MOS transistor 35 (36) simulates a resistance element having an on-resistance and an off-resistance. When the MOS transistor 35 (36) is operated in the triode region the on-resistance complies with

$$R_{ON} \;=\; \frac{1}{K \cdot [V_{GS} - V_T]} \;\;, \tag{1}$$

where $K$ is a MOS-transistor variable, $V_{GS}$ is a transistor voltage and $V_T$ is MOS-variable, and the on-resistance complies with

$$R_{OF} \approx \infty \;. \tag{2}$$

When the pulse signal has a period $T_P$ and a pulse width $W_P$, the on-resistance ($R_{ON}$) and the off-resistance ($R_{OF}$) of the MOS transistor 39 (40) will provide an effective resistance
The effective resistance ($R_{EF}$) results in the following cut-off frequency

$$R_{EF} \;=\; \frac{T_P}{W_P} \cdot R_{ON} \;\;. \tag{3}$$

$$f_{CO} \;=\; \frac{1}{2 \cdot \Pi \cdot R_{EF} \cdot C} \;\;, \tag{4}$$

where the capacitance 35 (36) has a value C.
By means of the above equations (1), (3) and (4) it is possible to illustrate that the coupling network in accordance with the invention can be realized without an unusual or undesirable value. For a customary choice of the MOS-transistor variable ($K$), the transistor voltage ($V_{GS}$) and the MOS variable ($V_T$),

$$K = 5.10^{-7} \ (A/V^{+2})$$

and

$$[V_{GS}\text{-}V_T] = 1 \ (V) \ ,$$

the on-resistance ($R_{ON}$) of the MOS transistor 39 (40) is

$$R_{ON} \ = \ \frac{1}{5.10^{-7} \ . \ [1])} \ = \ 2.10^{+6} \ (V/A) \ \ .$$

The on-resistance ($R_{ON}$) and a customary choice of the period ($T_P$) and the pulse width ($W_P$),

$$T_P = 150.10^{-3} \ (s)$$

and

$$W_P = 10.10^{-6} \ (s),$$

yield the following effective resistance ($R_{EF}$) of the MOS transistor 39 (40)

$$R_{EF} \ = \ \frac{150.10^{-3}}{10.10^{-6}} \ . \ 2.10^6 \ = \ 30.10^{+9} \ (V/A) \ \ .$$

If the value ($C$) chosen for the capacitance 35 (36) is large (in a (BI)MOS process),

$$C = 5.10^{-12} \ (F) \ ,$$

the cut-off frequency will be

$$f_{CO} \ = \ \frac{1}{2 \ . \ 3,14 \ . \ 30.10^{+9} \ . \ 5.10^{-12}} \ \approx \ 1 \ (Hz) \ \ .$$

The above example illustrates that a coupling network with a low cut-off frequency can be realized without the use of unusual values. Moreover, the dissipation is low because the MOS transistors 39 and 40 are switched by the pulse signal.

The invention is not limited to the embodiment shown. Within the scope of the invention several modifications will be conceivable to those skilled in the art. A possible modification, mentioned in the above description, concerns a connection between the first reference terminal (41) and the second reference terminal (42). As a result of this connection the MOS transistors and the output transistors will generally be of the same conductivity type (either N-type or P-type).

**Claims**

1. An integrated coupling network for converting an output signal of a first stage (10) into an input signal for a second stage (20), which coupling network comprises a first input terminal (31) for receiving the output signal, a first output terminal (33) for supplying the input signal, and a first capacitance (35) arranged between the first input terminal (31) and the first output terminal (33), characterized in that the coupling network further comprises a first output transistor (37) having a control electrode coupled to

4

the first input terminal (31) *via* the first capacitance (35) and having a main current path coupled between a first reference terminal (41) and the first output terminal (33), and a first MOS transistor (39) having a control electrode coupled to a terminal (30) for receiving a pulse signal and having a main current path coupled between a second reference terminal (42) and the control electrode of the first output transistor (37).

2. An integrated coupling network as claimed in Claim 1, characterized in that the coupling network further comprises a second input terminal (32) for receiving the output signal, a second output terminal (34) for supplying the input signal, a second capacitance (36), a second output transistor (38) having a control electrode coupled to the second input terminal (32) *via* the second capacitance (36) and having a main current path coupled between the first reference terminal (41) and the second output terminal (34), and a second MOS transistor (40) having a control electrode coupled to the terminal (30) for receiving the pulse signal and having a main current path coupled between the second reference terminal (42) and the control electrode of the second output transistor (38).

3. An integrated coupling network as claimed in Claim 1 or 2, characterized in that the first reference terminal (41) is connected to the second reference terminal (42).

European Patent Office

**EUROPEAN SEARCH REPORT**

Application Number

EP 92 20 4089

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | FR-A-2 138 234 (COMMISSARIAT A L'ENERGIE ATOMIQUE) * page 6, line 19 - page 8, line 19; figures 4,5 * | 1-3 | H03F3/393 H03H19/00 |
| A | PATENT ABSTRACTS OF JAPAN vol. 9, no. 19 (E-292)(1742) 25 January 1985 & JP-A-59 165 504 ( HITACHI SEISAKUSHO K.K. ) 18 September 1984 * abstract * | 1 | |
| A | ELEKTOR ELECTRONICS. vol. 12, no. 1, January 1986, LONDON GB pages 60 - 65 J. BARENDRECHT 'VARIABLE FILTER FOR DX' * page 61 - page 62; figures 2-4 * | 1,2 | |
| | | | TECHNICAL FIELDS SEARCHED (Int. Cl.5 ) H03F H03H |

The present search report has been drawn up for all claims

| Place of search | Date of completion of the search | Examiner |
|---|---|---|
| THE HAGUE | 17 MAY 1993 | TYBERGHIEN G.M. |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P0401)